# EUROPEAN PATENT APPLICATION

(11) **EP 1 860 663 A2**
(43) Date of publication of application: **28.11.2007**
(21) Application number: 07108975.9
(22) Date of filing: 25.05.2007
(51) Int. Cl.: G11C 27/02, G11C 13/04

(54) **Apparatus for processing an input signal**

(30) Priority: 26.05.2006 GB 0610517
(71) Applicant: Thales Holdings UK Plc, Addlestone, Surrey KT15 2NX (GB)
(72) Inventor: Davies, Jonathan, Newdigate Surrey RH5 5AT (GB); Brueil, Nicolas, Orsay 91400 (FR)
(74) Representative: Lucas, Laurent Jacques

(57) **Abstract**

Apparatus for processing an input signal comprises a first switching means and a second switching means, the first switching means comprises a first photoconductive switch and the second switching means comprises a second photoconductive switch, wherein the first switching means is switchable between an open state and a closed state in which it is adapted to pass the input signal to an output of the first switching means, the apparatus further comprises storage means connected to the output of the first switching means and to an output of the second switching means and adapted to store an output signal comprising the difference between a signal at the output of the first switching means when in its closed state and a signal at an output of the second switching means.

## Description

The present invention relates to an apparatus for and method of processing an input signal, and in particular to an apparatus for and method of performing a sample and hold operation on a high frequency input signal, such as a microwave input signal.

The sampling of a high frequency input signal, such as a microwave input signal, places great demands on the apparatus used for the sampling, and requires the use of fast devices in order to provide suitably high frequency sampling rates.

Apparatus known in the art use GaAs-based switches to sample a high frequency input signal. However, typically such switches are triggered using electronic signals which limits their speed of operation, and which in turn limits the maximum frequency of the signal which can usefully be sampled by an apparatus using such switches. Even the fastest of such prior art apparatus are limited to being able to sample input signals of up to around only 7GHz.

In order to increase speed of operation, optically triggered GaAs-based switches have been used in alternative prior art apparatus.

One such alternative prior art apparatus is described, for instance, in IEEE Journal of Solid State Circuits, Vol. 38, No.12, pages 2021 to 2030. In that apparatus, an optically triggered GaAs photoconductive switch is used to sample an input signal. A problem with using photoconductive switches is that extraneous signals, for instance feedthrough currents, can be large and can cause inaccuracy in the sampling measurement. In the aforementioned alternative prior art apparatus a dummy switch is used in feedthrough cancellation, but the use of that dummy switch can in turn cause additional measurement errors, not least because it relies upon the matching of two parasitic capacitances.

It is an aim of the present invention to address problems associated with prior art apparatus and methods and to provide an improved, or at least alternative, apparatus and method for processing an input signal.

In a first aspect there is provided apparatus for processing an input signal, comprising a first switching means and a second switching means, the first switching means comprising a first photoconductive switch and the second switching means comprising a second photoconductive switch, wherein the first switching means is switchable between an open state and a closed state in which it is adapted to pass the input signal to an output of the first switching means, the apparatus further comprising storage means connected to the output of the first switching means and to an output of the second switching means and adapted to store an output signal comprising the difference between a signal at the output of the first switching means when in its closed state and a signal at an output of the second switching means. Preferably, the first switching means and the second switching means are arranged such that, when the input signal is present at an input of the first switching means and at an input of the second switching means a signal at the output of the first switching means due to passage of the input signal through the first switching means in its open state is substantially the same as a signal at the output of the second switching means due to passage of the input signal through the second switching means in its open state.

Preferably, by the signal at the output of the first switching means due to passage of the input signal through the first switching means in its open state being substantially the same as the signal at the output of the second switching means due to passage of the input signal through the second switching means in its open state is meant that on average during the time when the first switching means and the second switching means are both in their open state, the value of the instantaneous voltage at the output of the first switching means due to passage of the input signal through the first switching means in its open state is within 25%, preferably within 5%, more preferably within 1 % of the value of the instantaneous voltage at the output of the second switching means due to passage of the input signal through the second switching means in its open state. Those figures exclude, for instance, any differential voltage between the output of the first switching means and the output of the second switching means caused by any stored voltage on the storage means, for instance a storage capacitor, due to a previous sampling of the input signal.

The input signal is typically a time varying signal, and the output signal may comprise a sample of the input signal.

Preferably extraneous signals appearing at the output of the first switching means when in its open state and at the output of the second switching means when in its open state are at least partially cancelled, and preferably are completely cancelled, in the output signal. Thus, the sample of the input signal or a portion of the sample of the input signal may be more accurately measured.

Extraneous signals may include, in particular, leakthrough signals. Leakthrough of signals (particularly high frequency signals such as microwave signals) through photoconductive switches in their open state can be significant, due to the relatively high capacitance of such switches. Other extraneous signals may include, for instance, radio-frequency interference signals.

In the situation where the output signal is stored in the storage means and then the first photoconductive switch and the second photoconductive switch are switched to their respective open states, the signal at the output of the first switching means may be different to the signal at the output of the second switching means. For instance the voltage at the output of the first switching means may be different to the voltage at the output of the second switching means by the amount of a d.c. voltage stored on the storage means. However, preferably any additional voltage at the output of the first switching means in its open state due to leakthrough of the input signal is substantially the same as any additional voltage at the output of the second switching means in its open state, in which case preferably any leakthrough of the input signal would not change the signal stored on the storage means.

Preferably the apparatus further comprises processing means adapted to read the output signal from the storage means.

The processing means may be adapted to read the output signal from the storage means when the first switching means is in its open state. Thus the input signal may be sampled over a short period of time, when the first switching means is in its closed state, and the sample may subsequently be read from the storage means even after the first switching means has moved from its closed state to its open state. Thus more time may be provided for the reading of the output signal. Thus also the sampling of the input signal may be separated from the reading of the sample from the storage means and shorter sampling periods may be provided than otherwise might have been possible.

That feature is particularly important and so in a further independent aspect there is provided apparatus for processing an input signal, comprising a first switching means and a second switching means, the first switching means comprising a first photoconductive switch and the second switching means comprising a second photoconductive switch, wherein the first switching means is switchable between an open state and a closed state in which it is adapted to pass the input signal to an output of the first switching means, the apparatus further comprising storage means adapted to store an output signal comprising the difference between a signal at the output of the first switching means when in its closed state and a signal at an output of the second switching means, and processing means adapted to read the output signal from the storage means when the first switching means is in its open state.

Preferably the first switching means and the second switching means are arranged in a bridge arrangement, preferably a capacitive bridge arrangement.

By a bridge arrangement is meant any arrangement of electrical components which, under particular conditions, provides substantially the same signal (for instance substantially the same current or substantially the same potential) at at least two points. When those particular conditions pertain the bridge is said to be balanced. The conditions may pertain when switches are closed or opened. Preferably, the bridge arrangement is balanced when the first switching means is in its open state and the second switching means is in its open state. Preferably the at least two points are the output of the first switching means and the output of the second switching means.

That feature is particularly important and so in a further independent aspect there is provided apparatus for processing an input signal, comprising a first switching means and a second switching means, the first switching means comprising a first photoconductive switch and the second switching means comprising a second photoconductive switch, wherein the first switching means is switchable between an open state and a closed state in which it is adapted to pass the input signal to an output of the first switching means, and the first switching means and the second switching means are arranged in a bridge arrangement, preferably a capacitive bridge arrangement.

The bridge arrangement may be arranged to balance when the first switching means and the second switching means are each in their respective open state.

Preferably the first switching means comprises a third photoconductive switch and the second switching means comprises a fourth photoconductive switch and the first, second, third and fourth photoconductive switches are arranged so as to form the bridge arrangement.

In one particularly advantageous arrangement, the output of the first switching means may be located between the output of the first photoconductive switch and the input of the third photoconductive switch, and the output of the second switching means may be located between the output of the second photoconductive switch and the input of the fourth photoconductive switch.

Preferably the output of the third photoconductive switch and the output of the fourth photoconductive switch are both at the same potential, and preferably are both at ground.

Preferably the fourth photoconductive switch is adapted to move between an open state and a closed state in which it connects the output of the second switching means, and preferably the apparatus is arranged to operate so that the fourth photoconductive switch closes at the same time as the first photoconductive switch.

The apparatus may be arranged so that the output signal stored in the storage means is maintained after switching of the first switching means from the closed state to the open state.

Preferably the apparatus further comprises means for connecting the output of the second switching means to a known potential when the first switching means is in a closed state, and preferably the known potential is ground.

The second switching means may be considered to be in a closed state when the output of the second switching means is connected to the known potential. In that case when the first switching means and the second switching means are in their respective closed states the input signal may pass to the output of the first switching means, the output of the second switching means may be connected to a known potential, and the output signal may comprise the difference between the input signal at that time and the known potential.

The processing means may be adapted to store a sample of the input signal when both the first switching means and second switching means are in a closed state. Preferably the stored sample of the input signal appears at the output while the first switching means and second switching means are both in a closed state and remains at the output after the first switching means and second switching means have both returned to an open state, until cleared by time dependent discharge or by a clearing means.

Preferably the first switching means is substantially the same as the second switching means. Preferably the first switching means has substantially the same impedance when in the open state as the second switching means, at the frequency of the input signal.

The or each photoconductive switch included in the first switching means may be substantially the same as a respective equivalent photoconductive switch included in the second switching means.

In particular, preferably the or each photoconductive switch included in the first switching means has substantially the same capacitance as a respective equivalent photoconductive switch included in the second switching means.

Thus, a leakthrough signal at the output of the first switching means may be the same as, or similar to, a leakthrough signal at the output of the second switching means, and those leakthrough signals may be at least partially cancelled in the output signal stored in the storage means.

By two photoconductive switches having substantially the same capacitance is meant that one of the switches has a value of capacitance within 5%, preferably within 1% of the value of capacitance of the other of the switches.

Preferably the first switching means and the second switching means are arranged symmetrically.

The first switching means and the second switching means may be arranged so that the input signal is passed to an input of the first switching means and to an input of the second switching means. The input signal may be split before being passed to the input of the first switching means and to the input of the second switching means, and thus a portion of the input signal may be passed to the input of the first switching means at the same time as a corresponding portion of the input signal is passed to the input of the second switching means.

The output of the first switching means and the output of the second switching means may each be connected directly to the storage means. So, for instance, the output of the first switching means and the output of the second switching means may each be connected to the storage means by a respective electrically conducting path, with no other electrical components being present between the output of the first switching means and the storage means or between the output of the second switching means and the storage means.

Preferably the storage means comprises a capacitor and the output of the first switching means is connected to one side of the capacitor and the output of the second switching means is connected to the other side of the capacitor. Thus a simple and effective way of storing a signal from the output of the first switching means and storing a signal from the output of the second switching means may be provided.

The apparatus may further comprise a further switching means operable to direct the input signal away from the first switching means and/or the second switching means.

Thus the timing of the sampling of the input signal may be more accurately controlled.

It is a discovery pursuant to the present invention the electrical conductivity of a photoconductive switch may drop after a certain period of time (100 picoseconds or so, in one example) after the photoconductive switch has initially entered the closed state. It is preferred to cease the sampling of the input signal using the first switching means before such drop in electrical conductivity of the photoconductive switch included in the first switching means.

Accordingly, the further switching means may be adapted to direct the input signal away from the first switching means at a time after the first switching means has been initially moved to its closed state.

The further switching means may be adapted to direct the input signal away from the first switching means at a pre-determined time after a closing of the first switching means. Preferably the pre-determined time is between 50 picoseconds and 150 picoseconds, preferably between 70 and 130 picoseconds and more preferably 100 picoseconds.

Preferably the first switching means is switchable from the open state to the closed state by application of an optical pulse, and preferably the second switching means is switchable from the open state to a closed state by application of an optical pulse.

The apparatus may further comprise control means adapted to carry out a sequence of operations using the first switching means and/or the second switching means. The sequence of operations may comprise sampling the input signal by closing and opening the first switching means and preferably also closing and opening the second switching means.

Preferably the sequence of operations also includes operating the further switching means and/or operating the clearing means and/or operating the means for connecting the output of the second switching means to a known potential.

Preferably the control means is adapted to repeat the sequence of operations. Thus the input signal may be sampled repetitively. The control means may repeatedly switch the first switching means between a closed state and an open state by application of a periodic optical signal of a selected frequency to the or a photoconductive switch included in the first switching means.

Preferably the control means is adapted to carry out the sequence of operations in dependence upon a timing signal. The timing signal may comprise a series of pulses and the control means may be adapted to repeat the sequence of operations in dependence upon the pulse repetition frequency. Preferably the pulse repetition frequency is in a range from 400 MHz to 40 GHz, preferably in a range from 1 GHz to 10 GHz, and more preferably in a range from 1 GHz to 2 GHz.

The timing signal may comprise an optical signal, preferably a laser signal with a low timing jitter to minimise sampling noise.

Thus the control means may be adapted to apply a sequence of optical pulses to the first switching means and/or the second switching means at a pulse repetition rate in the range 400 MHz to 40 GHz, preferably in the range 1 GHz to 10 GHz, and more preferably in the range 1 GHz to 2 GHz.

Preferably the input signal comprises a microwave signal. The input signal may have a frequency or frequencies in a range from 100 MHz to 300 GHz, preferably in the range from 500 MHz to 40 GHz, and more preferably in the range from 2 GHz to 20 GHz.

Preferably the control means is adapted to control the operation of the first switching means and/or the second switching and/or the operation of the further switching means and/or the clearing means by directing the or an optical signal to the photoconductive switch included in the first switching means and/or directing the or an optical signal to the photoconductive switch included in the second switching means and/or directing the or an optical signal to a photoconductive switch included in the further switching means and/or directing the or an optical signal to a photoconductive switch included in the clearing means.

The control means may comprise means for controlling the arrival time of the optical signal at the first switching means and/or the second switching means and/or the further switching means and/or the clearing means, thereby controlling the relative timing of operation of the first switching means and/or the second switching means and/or the further switching means and/or the clearing means.

The photoconductive switch included in the first switching means and the photoconductive switch included in the second switching means may be formed on a single substrate, and preferably any other photoconductive switches included in the apparatus are formed on the substrate.

The single substrate may, for instance, comprise a single piece of semiconductor, such as a GaAs chip. The single substrate may have a plurality of layers.

Preferably the first switching means and the second switching means are formed on the substrate.

Preferably no other components included in the apparatus are located on the substrate or the only other component located on the substrate is a capacitor.

Preferably the only electrical components included on the substrate are photoconductive switches, conductive tracks, and connection regions enabling mounting of a storage capacitor as well as electrical connections to be made to the substrate.

Preferably the substrate comprises GaAs, preferably low-temperature grown GaAs.

The photoconductive switches may be formed by photolithography and/or molecular beam epitaxy applied to a or the substrate.

Preferably the processing means comprises a differencing device, preferably connected to outputs of the storage means. Preferably the output signal, in the form of a stored voltage on the storage capacitor, is passed to the outputs of the apparatus through a differencing device.

The differencing device may comprise a differential buffer amplifier or an r.f. power combiner.

In a further independent aspect there is provided a method of processing an input signal, comprising providing a first switching means and a second switching means and a storage means connected to an output of the first switching means and to an output of the second switching means, each of the first switching means and the second switching means comprising a respective photoconductive switch, passing an input signal to the first switching means and to the second switching means, switching the first switching means from its open state to its closed state in which the input signal passes to an output of the first switching means, storing in the storage means an output signal comprising the difference between the signal at the output of the first switching means in its closed state and the signal at an output of the second switching means, switching the first switching means from its closed state to its open state, and reading the output signal from the storage means when the first switching means is in its open state.

Preferably the method further comprises reading the output signal from the storage means, preferably when the first switching means is in its open state.

That feature is particularly important and so in a further independent aspect there is provided a method of processing an input signal, comprising providing a first switching means and a second switching means, each of the first switching means and the second switching means comprising a respective photoconductive switch, passing an input signal to the first switching means and to the second switching means, switching the first switching means from its open state to its closed state in which the input signal passes to an output of the first switching means, storing in a storage means an output signal comprising the difference between the signal at the output of the first switching means in its closed state and the signal at an output of the second switching means, switching the first switching means from its closed state to its open state, and reading the output signal from the storage means when the first switching means is in its open state.

The method may further comprise arranging the first switching means and the second switching means in a bridge arrangement, preferably a capacitive bridge arrangement.

That feature is particularly important and so in a further independent aspect there is provided a method of processing an input signal, comprising providing a first switching means and a second switching means arranged in a bridge arrangement, each of the first switching means and the second switching means comprising a respective photoconductive switch, the first switching means being moveable between an open state and a closed state in which it is adapted to pass the input signal to an output of the first switching means.

The bridge arrangement may be arranged to balance when the first switching means and the second switching means are each in a respective open state.

The first switching means may comprise a third photoconductive switch and the second switching means may comprise a fourth photoconductive switch and the method may comprise arranging the first, second, third and fourth photoconductive switches so as to form the bridge arrangement.

Any feature in one aspect of the invention may be applied to another aspect of the invention, in any appropriate combination. In particular, apparatus features may be applied to method features and *vice versa.*

Preferred features of an embodiment of the invention will now be described, purely by way of example, and with reference to the accompanying drawings in which:-
Figure 1 is a circuit diagram of a GaAs chip included in an optical sample and hold apparatus in the preferred embodiment;
Figure 2 is a diagram showing the mask layout used to produce a variant of the GaAs chip of Figure 1;
Figure 3A is a circuit diagram of apparatus in the preferred embodiment, with an AD8351 lF differential amplifier on the IF substrate;
Figure 3B is a circuit diagram of apparatus of a variant of the preferred embodiment, with an RF combiner on the IF substrate;
Figure 4A is a photograph of a physical representation of part of the apparatus of Figure 3A; and
Figure 4B is a photograph of a physical representation of part of the apparatus of Figure 3B and an associated circuit diagram.

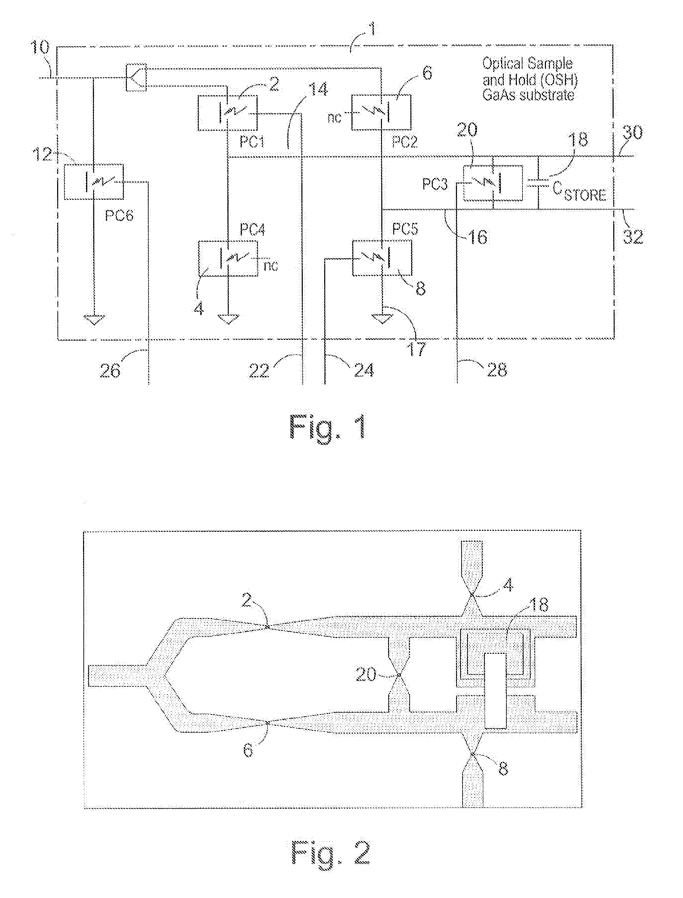

Figure 1 is a circuit diagram of a GaAs chip 1 included in an apparatus according to the preferred embodiment. In this case the apparatus is a sample and hold apparatus for sampling a microwave input signal.

The apparatus includes a first arrangement of switches, comprising photoconductive switch 2 and photoconductive switch 4, and a second arrangement of switches comprising photoconductive switch 6 and photoconductive switch 8.

Each of the photoconductive switches consists of a 1 µm gap in gold conductor tracks which are fabricated by vapour-deposition onto the GaAs chip 1. The gold conductor tracks form the connections between the various photoconductive switches shown in Figure 1.

To minimise the on-resistance in the illuminated or closed state, five 1µm wide gold tracks on the input side of the photoconductive switch are inter-digitated with five 1 µm gold tracks on the output side of the photoconductive switch. Each of the five inter-digitated 'fingers' on the input has a 20µm length and is separated from the five 20µm long fingers on the output by 1 µm of each side and 1 µm on each end. The photoconductive switch covers an area of approximately 20µm by 20µm, which is slightly larger than the illuminated spot from the laser, thereby facilitating spot alignment.

Considering the connections between the various photoconductive switches, an input 10 is connected via a splitter to an input of photoconductive switch 2 of the first arrangement of switches and to an input of photoconductive switch 6 of the second arrangement of switches. The input 10 is also connected to an input of a further photoconductive switch 12. In operation, an input signal is passed to the apparatus through input 10. The preferred embodiment is suitable in particular for processing of an input signal comprising a frequency or frequencies within the range 2 to 20 GHz.

An output 14 of the first arrangement of switches is located between the output of photoconductive switch 2 and an input of photoconductive switch 4, and an output 16 of the second arrangement of switches is located between the output of photoconductive switch 6 and an input of photoconductive switch 8.

The first arrangement of switches and the second arrangement of switches together form a bridge arrangement, with the output 14 of the first arrangement of switches and the output 16 of the second arrangement of switches being the outputs of the bridge arrangement.

The photoconductive switches 2 4 6 8 are such that significant leakage currents can pass through them even when they are in an open state, depending on the frequency of the input signal. The bridge arrangement ensures that when the photoconductive switches 2 4 6 8 included in the bridge arrangement are in an open state the leakage currents through the switches 2 6 at least partially cancel with one another.

Considering the question of leakage currents further, it can be seen that when all of photoconductive switches 2 4 6 8 are open, there may be a leakage of the input signal at input 10 through both photoconductive switch 2 and photoconductive switch 6. The leakage current through open photoconductive switch 2 can leak to ground through open photoconductive switch 4 and the leakage current through open photoconductive switch 6 can leak to ground through open photoconductive switch 8. If the photoconductive switches 2 4 6 8 all have similar electrical properties (and in particular, a similar impedance at the input signal frequency) then it would be expected that the signal at the output 14 of the first arrangement of switches due to leakage current through photoconductive switch 2 and the signal at the output 16 of the second arrangement of switches would be the same, or similar, and thus comparison of the signal at the outputs 14 and 16 provides at least partial cancellation of the leakage currents.

The apparatus also includes a storage capacitor 18 and it can be seen from Figure 1 that output 14 is connected directly to one side of the storage capacitor 18 and that output 16 is connected directly to the other side of the storage capacitor 18. A photoconductive switch 20 is located between the output 14 of the first arrangement of switches and the output 16 of the second arrangement of switches, and in parallel with storage capacitor 18.

Both inputs of a differential amplifier (not shown in Figure 1) are connected to a respective output 30 32 of the storage capacitor. The apparatus also includes an analogue to digital converter (not shown) connected to the outputs of the amplifiers. In the preferred embodiment the output of the analogue to digital converter is connected to a computer (not shown). The computer is programmed to store and accumulate output signals and to carry out signal averaging or other data processing operations on the output signals.

Optical inputs, in the form of fibre optic cables, are directed to certain of the photoconductive switches. In particular, optical input 22 is directed to photoconductive switch 2, optical input 24 is directed to photoconductive switch 8, and optical input 26 is directed to further photoconductive switch 12.

The preferred embodiment has only a single optical clear input directed to photoconductive switch 20. In an alternative embodiment, three optical inputs are directed to photoconductive switch 20 from a 6-way or 8-way optical splitter. By delaying the arrival of an optical pulse at the photoconductive switch 20 via one of the inputs by 270 ps, delaying the arrival of an optical pulse at the photoconductive switch 20 via the second of the inputs by 280 ps and delaying the arrival of an optical pulse at the photoconductive switch 20 via the third of the inputs by 290 ps, the clearing effect on the storage capacitor is strengthened.

Each optical input is directed to the portion of the GaAs chip located in the gap between the gold conductor tracks which form part of the respective photoconductive switch. In operation, a laser signal is sent through the optical input, illuminates the portion of the GaAs chip and causes excitation of electrons into the conduction band of the GaAs and consequently allows conduction of charge carriers across the gap between the gold conductor tracks. The photoconductive switch is considered to be in its closed state when thus illuminated. When the laser pulse ends, the electrons fall back out of the conduction band, the electrical conductivity drops and the photoconductive switch is considered to be in its open state.

It can be seen from Figure 1 that no optical input is provided to either photoconductive switch 4 or photoconductive switch 6 in the preferred embodiment. Photoconductive switch 4 and photoconductive switch 6 are always open.

From the preceding paragraphs it can be understood that by applying optical signals of appropriate lengths to the various photoconductive switches at appropriate points in time, the various photoconductive switches can be opened and closed in a desired sequence enabling the input signal, or a portion of the input signal, to be directed appropriately through the apparatus.

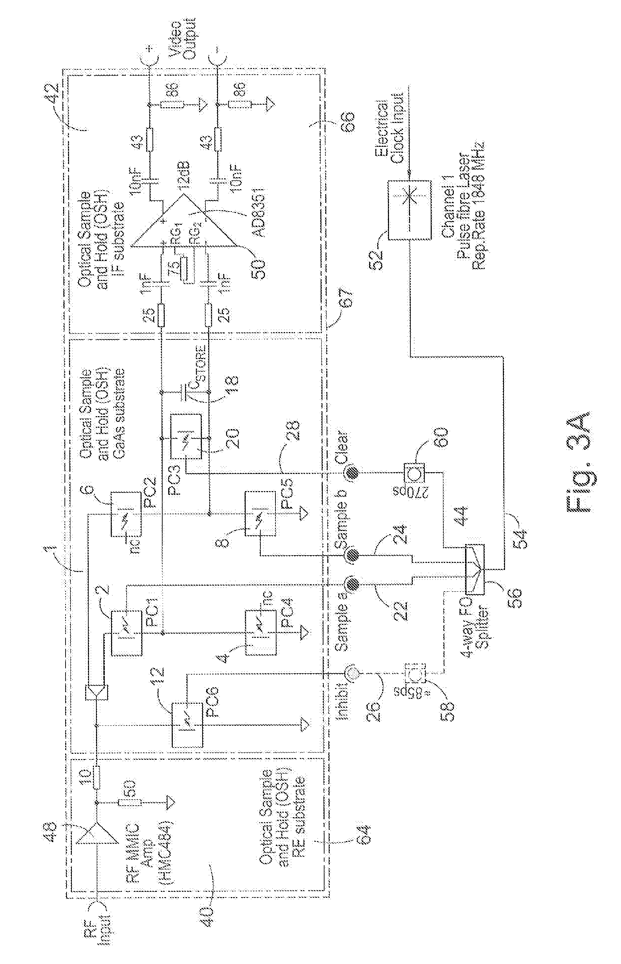

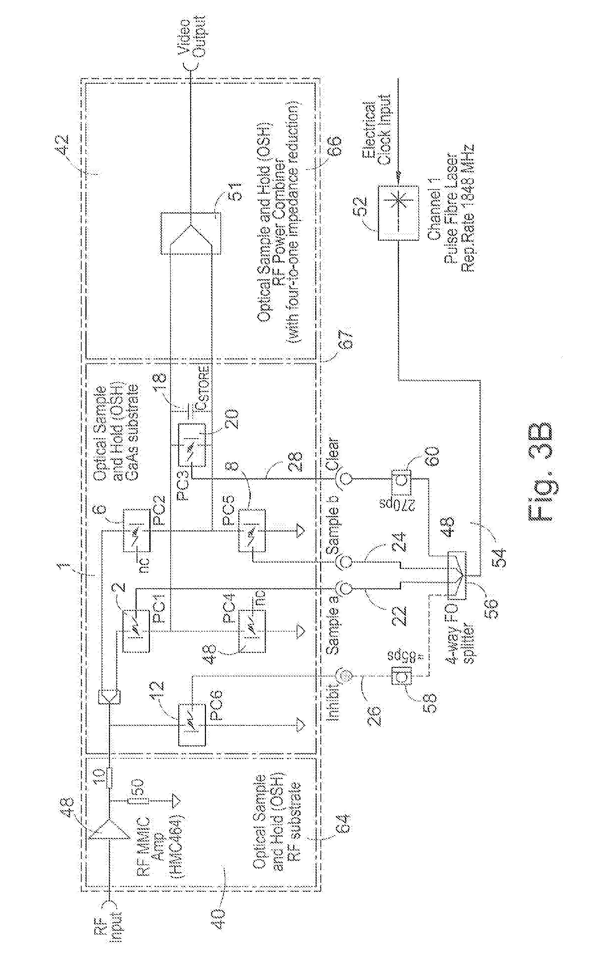

In the case of the preferred embodiment, the photoconductive switches are opened and closed in sequence so as to perform a sample and hold operation in which the input signal is sampled and the sample of the input signal is stored in the storage capacitor 18. The timing of a sample and hold operation, and the subsequent processing of the sampled signal, is described in detail in relation to Figures 3A and 3B, but firstly the sequence in which the photoconductive switches are opened and closed in a sample and hold operation is described in overview in relation to Figure 1.

### Sampling process

As a first step in the sequence, a respective optical pulse is sent through optical input 28. The optical pulse causes photoconductive switch 20 to close and thus to discharge storage capacitor 18. In a variant of the preferred embodiment, optical pulses are also sent to two additional optical inputs to the storage capacitor 18. Sequencing all three optical pulses one after the other helps to ensure that the storage capacitor is fully discharged.

At this point, all of the photoconductive switches in the bridge arrangement are open and, presuming the bridge is balanced, the signal at the output 14 of the first arrangement of switches is the same as, or as close as possible to, the signal at the output 16 of the second arrangement of switches. Thus the potential at one side of the storage capacitor 18 should be the same as, or as close as possible to, the potential at the other side of the storage capacitor 18.

The potential difference across the storage capacitor is amplified by the differential amplifier connected to outputs 30 32. At this time, the potential at both outputs is the same, or similar, so the output of the differential amplifier will be zero, or close to zero. The output of the differential amplifier is low-pass filtered before being further amplified by a conventional single-ended RF amplifier before connection to the analogue to digital converter.

In a variant of the preferred embodiment, the differential amplifier is replaced by an RF two-way power combiner connected to outputs 30 32. As in the preferred embodiment, the output of the RF power combiner is also the difference of the potentials at outputs 30 32. The output of the RF power combiner is therefore zero at this time. The output of the RF power combiner is low-pass filtered before being amplified by a conventional single-ended RF amplifier before connection to the analogue to digital converter.

Next, an optical pulse is sent through each of optical inputs 22 and 24 simultaneously, closing each of photoconductive switches 2 and 8 simultaneously.

When photoconductive switch 2 is closed, an input signal from input 10 is passed through photoconductive switch 2 to an output of photoconductive switch 2. The signal then passes through an output 14 of the first arrangement of switches, which connects to one side of the storage capacitor 18.

At the same time, when photoconductive switch 8 is closed, the second arrangement of switches is connected to the potential pertaining at the output 17 of photoconductive switch 8, in this case ground, completing the circuit that allows the storage capacitor 18 to charge to a voltage proportional to the input signal voltage. These connections can be seen from Figure 1. An output 16 of the second arrangement of switches connects to the other side of the storage capacitor 18.

It can be understood from the preceding paragraphs that when the photoconductive switches 2 and 8 are closed the input signal pertaining at that time is passed to the storage capacitor. Thus, the storage capacitor 18 stores a sample of the input signal.

The optical pulses used to close the photoconductive switches 2 8 are of length 5ps in a typical measurement carried out using the apparatus of the preferred embodiment. The length of the pulses can be set to be values other than 5ps if desired.

After the optical pulses used to close the photoconductive switches 2 8 have ended, the photoconductive switches 2 8 reopen. Any leakthrough signal through the photoconductive switch 2 is substantially the same as any leakthrough signal through the photoconductive switch 6, when photoconductive switches 2 8 are in their open state, as discussed later. Accordingly, the voltage stored on the storage capacitor 18 when the photoconductive switches 2 8 are closed does not change significantly upon reopening of photoconductive switches 2 8. Accordingly, the sample of the input signal stored on the storage capacitor can be read and processed after the photoconductive switches have reopened.

Next, an optical pulse is sent through optical input 26 to the further photoconductive switch 12, closing that switch and directing the input signal away from photoconductive switches 2 and 6. In the preferred embodiment, the optical pulse sent through optical input 26 arrives at the further photoconductive switch 12 shortly after (≈ 100 ps) the optical pulses sent through optical inputs 22 and 24 to illuminate photoconductive switches 2 and 8. However as the closing of photoconductive switch 12 directs the input signal away from photoconductive switch 2 it can be understood that any erroneous sampling of the input signal due to secondary carrier conductance effects in photoconductive switches 2 and 8 will be inhibited when photoconductive switch 12 is closed, as discussed in more detail below.

The timing of the arrival of optical pulse 26 at photoconductive switch 12 is arranged in dependence upon the time at which secondary carrier conductance effects from photoconductive switches 2 and 8 may occur. Usually the timing of the arrival of optical pulse 26 at photoconductive switch 12 is arranged to coincide with any such secondary carrier conductance effects.

At this time the potential difference stored on the storage capacitor 18 due to a sampling of the input signal can be considered to be a differential signal. The potential difference across the storage capacitor on outputs 30 32 is amplified by the differential amplifier to minimise the effects of common signals, such as input RF leakage, on the resultant output. The amplified signal is passed to the analogue to digital converter and then the converted signal is passed to the computer.

In the variant of the preferred embodiment where the differential amplifier is replaced by an RF, 2-way, power combiner, the power combiner performs the same differencing function of the two outputs 30 32 of the storage capacitor. The RF power combiner has a variable width meander line design to perform both the signal differencing and an impedance transformation from around 200 ohms at the storage capacitor to 50 ohms at the single output.

In this variant, the RF power combiner output is externally amplified by a single-ended RF amplifier. The amplified signal is passed to the analogue to digital converter and then the converted signal is passed to the computer.

In both of these variants, the computer obtains a measure of the input signal at the time of sampling.

It will be understood that, generally, the sequence of operations described above will be repeated and, rather than obtaining, and processing, only a single differential signal, many differential signals will be obtained. The differential signals are typically stored, and/or signal processed, typically using Fourier transforms, for instance fast Fourier transforms, or other data processing techniques, either before or after comparing them one to another. In particular the computer is, in most circumstances, used to compare the sum, difference, average or data transform of many differential signals.

The length of time for which the input signal is sampled is equal to the overlap of the two optical pulses at photoconductive switches 2 and 8. In the current embodiment these pulses have a 5 ps width. Provided these pulses coincide well, the duration of sampling will also be 5 ps. The length of time for which the input signal is sampled is chosen in dependence on the frequency of the input signal. Typically, this signal should be roughly one tenth of the period of the maximum RF input frequency to be sampled.

The length of time for which the sampled input signal is held is equal to the difference between the arrival time of the optical pulses at photoconductive switches 2 and 8, and the arrival time of the optical pulse at photoconductive switch 20, when the sampled voltage is cleared. During this time, the voltage on the storage capacitance will be subject to a slow but continuous discharge effect due to the impedance of the load on the subsequent IF substrate.

The sampling rate is also chosen in dependence on the frequency of the input signal. For Nyquist sampling, the sample rate should be twice the frequency of the maximum RF input frequency to be sampled. For sub-Nyquist sampling, the sample rate should be less than twice the RF input frequency. In the latter mode of operation, frequency ambiguities and increased noise are likely to be present in the sampled data.

It has also been found that, depending on the manufacturing method for the low temperature GaAs used to fabricate the photoconductive switch, secondary carrier conductance effects may cause the electrical conductivity of each photoconductive switch 2 8 to temporarily drop after a certain period of time (typically 100 picoseconds or so) after the arrival of the laser pulse. As mentioned above, in the preferred embodiment an optical pulse is sent through optical input 26 to the further photoconductive switch 12 in order to direct the input signal away from the inputs to the photoconductive switches 2 6 before such secondary carried conductance effects occur.
It has been demonstrated that when the growing process of low temperature GaAs is controlled carefully, all of the secondary carrier conductance effects can be eliminated. In variants of the preferred embodiment, GaAs of this quality is used and illumination of the further photoconductive switch 12 is not required.

### Balancing of the bridge arrangement

It has been mentioned above that the bridge arrangement of the first and second arrangement of photoconductive switches can provide cancellation of leakage currents through the photoconductive switches, or other extraneous signals.

In order to provide the maximum cancellation of leakage currents, the first and second arrangements of switches are arranged to be as similar as possible. In particular each of the photoconductive switches 2 4 6 8 is arranged to have, as far as possible, the same capacitance.

In making the photoconductive switches, care is taken to use a GaAs chip which has a dielectric constant which is substantially the same across the whole of the chip, and to ensure that each of the gold conductor tracks have substantially the same characteristics, thereby to ensure that the capacitance of each photoconductive switch is the same.

The photoconductive switches and the conductive tracks linking them on the GaAs chip are also arranged in a symmetrical arrangement in the preferred embodiment. This can be appreciated from consideration of Figure 2, which shows the mask layout used in deposition of the gold conductor tracks on the GaAs chip to produce a variant of the preferred embodiment. Like reference numerals are used to refer to like features in Figure 2, and it can be seen that the variant of the preferred embodiment illustrated in Figure 2 does not include the further photoconductive switch 12.

### Input and output circuitry and timing of operation

More detail is now provided concerning the timing of the sample and hold operation and concerning input and output circuitry connected to the GaAs chip, with reference to Figures 3A and 3B, in which like reference numerals have been used to refer to like features.
Figure 3A is a circuit diagram of the preferred embodiment of Figure 1.
Figure 3B is a circuit diagram of a variant of the preferred embodiment.

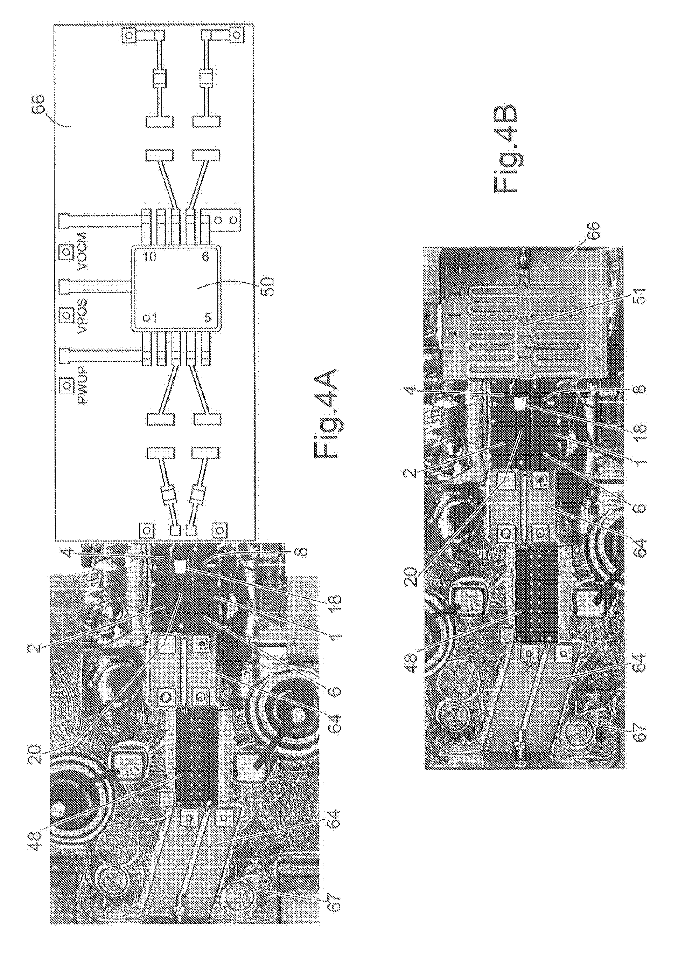

Figure 4A shows a photograph of the physical implementation of this preferred embodiment. Figure 3A shows some of the input circuitry 40, some of the output circuitry 42, and some of the optical input circuitry 44 in addition to the circuitry on the GaAs chip 1. The GaAs chip is shown in the photographs in Figure 4A and 4B and also in more detail in the mask diagram in Figure 2.

Both the preferred embodiment shown in Figure 3A and the variant shown in Figure 3B include a separate storage capacitor 18. In an alternative embodiment, the capacitance of photoconductive switch 20 is increased twenty fold by increasing both the number of interdigitated gold tracks and their overlap length with the tracks on the other side of the switch. In that alternative embodiment, the photoconductive switch 20 has sufficient capacitance to function as the storage capacitor, and not to require an additional capacitor 18.

The input circuitry of both Figure 3A and 3B includes a Hittite HMC464 radio-frequency monolithic microwave integrated circuit (MMIC) amplifier 48 for amplifying the input signal before passing it to the sample and hold circuitry on the GaAs chip.

The output circuitry in Figure 3A and 4A includes a differential amplifier of Analog Devices AD8351, each input connected to one side of the storage capacitor 18. The outputs of the differential amplifier are passed to further processing circuitry (not shown) which includes an analogue to digital converter and a computer.

The output circuitry in Figure 3B and 4B consists of a passive RF power combiner implemented in this embodiment with an impedance-converting meander transmission line. This device not only forms the difference of the two outputs from the storage capacitor 30 32, but also converts the impedance from 200 ohms at the storage capacitor to 50 ohms at the Video IF output. The Video IF output is amplified in a single-ended IF amplifier and then passed to further processing circuitry (not shown) which includes an analogue to digital converter and a computer.

It is a feature of the embodiments of Figures 3A, 3B, 4A and 4B that, other than the photoconductive switches and the conductive tracks linking the photoconductive switches, only one additional component is mounted on the GaAs substrate, namely the storage capacitor 18. Each of input circuitry 40 and output circuitry 42 is contained on an alumina substrate tile 64 66, respectively, indicated by alternate dashed and dotted lines in Figure 3A and 3B.

The physical layout of the alumina substrate tiles 64 66 and the GaAs chip 1 is shown in Figure 4B, which is a photograph of the physical prototype. This photograph shows the alumina substrate tile 64 and 66 , as well as a photograph of GaAs substrate 1. Figure 4A shows photographs of the alumina substrate tile 64, as well as a photograph of GaAs substrate 1, but substrate tile 66 is represented by a mask drawing. It can be seen that the GaAs chip 1 is located between the two alumina substrate tiles 64 66 in both embodiments. The GaAs chip and the two alumina substrate tiles are located in a single compartment 67 of a screened, hermetically sealed metal housing in both embodiments (shown in Figure 3A and 3B by a dotted line). In both cases, the GaAs chip is roughly 2.7mm long by 2mm wide. A single female SMA connector is used to connect the RF input to the input of the amplifier 48. Two female SMA connectors are used to connect to the two differential outputs of the differential amplifier.

In the variant shown in Figure 4B, that uses the RF power combiner in place of the AD8351 differential amplifier, the internal housing is roughly 18 mm long internally and has only one female SMA connector on the output. The preferred embodiment shown in Figure 4A has an overall housing internal length of roughly 30 mm, to allow sufficient space for the AD8351 substrate.

Returning to consideration of Figures 3A and 3B, the optical input circuitry includes a pulse fibre laser 52 set up to produce a series of laser pulses with a pulse repetition frequency in the range 1666 MHz to 2000 MHz. Each laser pulse in the series is passed via fibre optic cable 54 to a four-way fibre optic splitter 56. There each pulse is split into four separate pulses, and each of those four separate pulses is passed to a respective one of the optical inputs 22 24 26 28.

A first delay device 58 is positioned between the optical splitter 56 and the optical input 26, and a second delay device 60 is positioned between the optical splitter 56 and the optical input 28. Each of these delay devices is implemented by an additional length of fibre optic cable.

The delay devices 58 and 60 are chosen, and the optical input circuitry is arranged, to ensure that for each pulse in the series of laser pulses a pulse arrives simultaneously at each of optical inputs 22 and 24, that a pulse arrives at optical input 26 after a first delay time, thus closing photoconductive switch 12, and that a pulse arrives at optical input 28 after a second delay time, thus closing photoconductive switch 28 and clearing the storage capacitor.

For the both variants illustrated in Figures 3A and 3B, the first delay time is chosen to be around 100 picoseconds and the second delay time is chosen to be around 270 picoseconds. In the current embodiment, the pulse repetition time is in the range 500-600 picoseconds and the duration of each pulse is around 5 picoseconds.

The apparatus can be easily adapted to operate with pulse repetition times as short as 25ps, by reducing the delay times and pulse width appropriately.

The sequence of events in a single cycle of operation of the sample and hold device of both Figure 3A and 3B is now considered. The sampling of the input signal starts at time zero when the leading edges of laser pulses arrive simultaneously at optical inputs 22 and 24, closing photoconductive switches 2 and 8. Sampling of the input signal stops 5ps later when the laser pulse ceases and switches 2 and 8 re-open. Around 100ps after time zero the leading edge of a laser pulse arrives at optical input 26 closing photoconductive switch 12, preventing any additional, erroneous, sampling of the input signal due to secondary carrier leakage effects. A further 170 picoseconds later, any remaining stored signal on the storage capacitor is cleared when the leading edge of a laser pulse arrives at optical input 28 closing photoconductive switch 20. A further approximately 270 picoseconds later, the leading edges of further pulses arrive simultaneously at optical inputs 22 and 24, closing photoconductive switches 2 and 8 and beginning the next cycle of operation of the sample and hold device.

In a variant of the two embodiments in Figure 3A and 3B, a 6-way optical splitter replaces the indicated 4-way optical splitter within the Optical Manifold 44. Three of the outputs from this alternative optical splitter are directed at optical inputs 22 24 26 exactly as in the two pictured embodiments. Optical input 28, however, is supplemented by two additional outputs from the splitter connecting to two additional optical inputs which are also directed at photoconductive switch 18. An optical pulse arrives at photoconductive switch 18 via optical input 28 at around 270 ps after time zero, and additional delays cause optical pulses to arrive at photoconductive switch 18 via the two further optical inputs at around 280 ps and around 290 ps respectively after time zero. This triple pulse approach results in an enhanced clearing of storage capacitor 18.

In a further variant of the embodiments already described, a separate laser diode is used to provide a clear pulse to the storage capacitor 18. Triggered electrically 270 ps after time zero, the laser diode outputs an approximately 200 ps wide optical pulse results in a further improvement in the clearing of storage capacitor 18.

It will be understood that the invention has been described above purely by way of example, and modifications of detail can be made within the scope of the invention.

Each feature disclosed in the description and (where appropriate) the claims and drawings may be provided independently or in any appropriate combination.

## Claims

1. Apparatus for processing an input signal, comprising a first switching means and a second switching means, the first switching means comprising a first photoconductive switch and the second switching means comprising a second photoconductive switch, wherein the first switching means is switchable between an open state and a closed state in which it is adapted to pass the input signal to an output of the first switching means, the apparatus further comprising storage means connected to the output of the first switching means and to an output of the second switching means and adapted to store an output signal comprising the difference between a signal at the output of the first switching means when in its closed state and a signal at an output of the second switching means.

2. Apparatus according to Claim 1, wherein the first switching means and the second switching means are arranged such that, when the input signal is present at an input of the first switching means and at an input of the second switching means a signal at the output of the first switching means due to passage of the input signal through the first switching means in its open state is substantially the same as a signal at the output of the second switching means due to passage of the input signal through the second switching means in its open state.

3. Apparatus according to Claim 1 or 2, wherein the apparatus further comprises processing means adapted to read the output signal from the storage means.

4. Apparatus according to Claim 3, wherein the processing means is adapted to read the output signal from the storage means when the first switching means is in its open state.

5. Apparatus for processing an input signal, comprising a first switching means and a second switching means, the first switching means comprising a first photoconductive switch and the second switching means comprising a second photoconductive switch, wherein the first switching means is switchable between an open state and a closed state in which it is adapted to pass the input signal to an output of the first switching means, the apparatus further comprising storage means adapted to store an output signal comprising the difference between a signal at the output of the first switching means when in its closed state and a signal at an output of the second switching means, and processing means adapted to read the output signal from the storage means when the first switching means is in its open state.

6. Apparatus according to any preceding claim, wherein the first switching means and the second switching means are arranged in a bridge arrangement.

7. Apparatus for processing an input signal, comprising a first switching means and a second switching means, the first switching means comprising a first photoconductive switch and the second switching means comprising a second photoconductive switch, wherein the first switching means is switchable between an open state and a closed state in which it is adapted to pass the input signal to an output of the first switching means, and the first switching means and the second switching means are arranged in a bridge arrangement.

8. Apparatus according to Claim 6 or 7, wherein the bridge arrangement is a capacitive bridge arrangement.

9. Apparatus according to any of Claims 6 to 8, wherein the bridge arrangement is arranged to balance when the first switching means and the second switching means are each in their respective open state.

10. Apparatus according to any of Claims 6 to 9, wherein the first switching means comprises a third photoconductive switch and the second switching means comprises a fourth photoconductive switch and the first, second, third and fourth photoconductive switches are arranged so as to form the bridge arrangement.

11. Apparatus according to any preceding claim, arranged so that the output signal stored in the storage means is maintained after switching of the first switching means from the closed state to the open state.

12. Apparatus according to any preceding claim, wherein the apparatus further comprises means for connecting the output of the second switching means to a known potential when the first switching means is in a closed state, and preferably the known potential is ground.

13. Apparatus according to any preceding claim, wherein the first switching means is substantially the same as the second switching means.

14. Apparatus according to any preceding claim, wherein the or each photoconductive switch included in the first switching means is substantially the same as a respective equivalent photoconductive switch included in the second switching means.

15. Apparatus according to any preceding claim, wherein the or each photoconductive switch included in the first switching means has substantially the same capacitance as a respective equivalent photoconductive switch included in the second switching means.

16. Apparatus according to any preceding claim, wherein the first switching means and the second switching means are arranged symmetrically.

17. Apparatus according to any preceding claim, wherein the first switching means and the second switching means are arranged so that the input signal is passed to an input of the first switching means and to an input of the second switching means.

18. Apparatus according to any preceding claim, wherein the output of the first switching means and the output of the second switching means are each connected directly to the storage means.

19. Apparatus according to any preceding claim, wherein the storage means comprises a capacitor and the output of the first switching means is connected to one side of the capacitor and the output of the second switching means is connected to the other side of the capacitor.

20. Apparatus according to any preceding claim, comprising a further switching means operable to direct the input signal away from the first switching means and/or the second switching means.

21. Apparatus according to Claim 20, wherein the further switching means is adapted to direct the input signal away from the first switching means at a pre-determined time after a closing of the first switching means.

22. Apparatus according to Claim 21, wherein the pre-determined time is between 50 picoseconds and 150 picoseconds, preferably between 70 and 130 picoseconds and more preferably 100 picoseconds.

23. Apparatus according to any preceding claim, wherein the first switching means is switchable from the open state to the closed state by application of an optical pulse, and preferably the second switching means is switchable from the open state to a closed state by application of an optical pulse.

24. Apparatus according to any preceding claim, further comprising control means adapted to carry out a sequence of operations using the first switching means and/or the second switching means.

25. Apparatus according to Claim 24, wherein the sequence of operations comprises sampling the input signal by closing and opening the first switching means and preferably also closing and opening the second switching means.

26. Apparatus according to Claim 24 or 25, wherein the control means is adapted to apply a sequence of optical pulses to the first switching means and/or the second switching means at a pulse repetition rate in the range 400 MHz to 40 GHz, preferably in the range 1 GHz to 10 GHz, and more preferably in the range 1 GHz to 2 GHz.

27. Apparatus according to any preceding claim, wherein the input signal comprises a microwave signal.

28. Apparatus according to any preceding claim, wherein the input signal has a frequency in a range from 100 MHz to 300 GHz, preferably in the range from 500 MHz to 40 GHz, and more preferably in the range from 2 GHz to 20 GHz.

29. Apparatus according to any preceding claim, wherein the photoconductive switch included in the first switching means and the photoconductive switch included in the second switching means are formed on a single substrate, and preferably any other photoconductive switches included in the apparatus are formed on the substrate.

30. Apparatus according to Claim 29, wherein the first switching means and the second switching means are formed on the substrate.

31. Apparatus according to Claim 29 or 30, wherein no other components included in the apparatus are located on the substrate or wherein the only other component located on the substrate is a capacitor.

32. Apparatus according to any of Claims 29 to 31, wherein the substrate comprises GaAs, preferably low-temperature grown GaAs.

33. Apparatus according to Claim 3 or any of Claims 4 to 32 as dependent on Claim 3, wherein the processing means comprises a differencing device, preferably connected to outputs of the storage means.

34. Apparatus according to Claim 33, wherein the differencing device comprises a differential buffer amplifier or an r.f. power combiner.

35. A method of processing an input signal, comprising providing a first switching means and a second switching means and a storage means connected to an output of the first switching means and to an output of the second switching means, each of the first switching means and the second switching means comprising a respective photoconductive switch, passing an input signal to the first switching means and to the second switching means, switching the first switching means from its open state to its closed state in which the input signal passes to an output of the first switching means, storing in the storage means an output signal comprising the difference between the signal at the output of the first switching means in its closed state and the signal at an output of the second switching means, and switching the first switching means from its closed state to its open state.

36. A method according to Claim 35, further comprising arranging the first switching means and the second switching means such that a signal at the output of the first switching means due to passage of the input signal through the first switching means in its open state is substantially the same as a signal at the output of the second switching means due to passage of an input signal through the second switching means.

37. A method according to Claim 35 or 36, further comprising reading the output signal from the storage means, preferably when the first switching means is in its open state.

38. A method of processing an input signal, comprising providing a first switching means and a second switching means, each of the first switching means and the second switching means comprising a respective photoconductive switch, passing an input signal to the first switching means and to the second switching means, switching the first switching means from its open state to its closed state in which the input signal passes to an output of the first switching means, storing in a storage means an output signal comprising the difference between the signal at the output of the first switching means in its closed state and the signal at an output of the second switching means, switching the first switching means from its closed state to its open state, and reading the output signal from the storage means when the first switching means is in its open state.

39. A method according to any of Claims 35 to 38, further comprising arranging the first switching means and the second switching means in a bridge arrangement.

40. A method of processing an input signal, comprising providing a first switching means and a second switching means arranged in a bridge arrangement, each of the first switching means and the second switching means comprising a respective photoconductive switch, the first switching means being moveable between an open state and a closed state in which it is adapted to pass the input signal to an output of the first switching means.

41. A method according to Claim 39 or 40, wherein the bridge arrangement is a capacitive bridge arrangement.

42. A method according to any of Claims 39 to 41, wherein the bridge arrangement is arranged to balance when the first switching means and the second switching means are each in a respective open state.

43. A method according to any of Claims 39 to 42, wherein the first switching means comprises a third photoconductive switch and the second switching means comprises a fourth photoconductive switch and the method comprises arranging the first, second, third and fourth photoconductive switches so as to form the bridge arrangement.

44. Apparatus for processing an input signal substantially as described herein with reference to the accompanying drawings.

45. A method of processing an input signal substantially as described herein with reference to the accompanying drawings.
